# EUROPEAN PATENT SPECIFICATION

(11) **EP 2 228 791 B1**
(45) Date of publication and mention of the grant of the patent: **06.05.2015**
(21) Application number: 10167970.2
(22) Date of filing: 21.03.2005
(51) Int. Cl.: G10L 19/00

(54) **Scalable lossless audio codec and authoring tool**
Skalierbarer verlustloser Audio-codec und Herstellungs-werkzeug
Système authoring et codec audio, sans perte et scalable

(30) Priority: 25.03.2004 US 556183 P; 04.08.2004 US 911062; 04.08.2004 US 911067
(43) Date of publication of application: 15.09.2010
(62) Divisional of application: 05728310.3
(73) Proprietor: DTS, Inc., Calabasas, CA 91302 (US)
(72) Inventor: Fejzo, Zoran, Los Angeles, CA 90049 (US)
(74) Representative: South, Nicholas Geoffrey

(56) References cited:
- EP-A- 0 869 620
- EP-A1- 1 054 514
- US-A1- 2003 179 938
- CRAVEN P ET AL: "LOSSLESS CODING FOR AUDIO DISCS" JOURNAL OF THE AUDIO ENGINEERING SOCIETY, AUDIO ENGINEERING SOCIETY, NEW YORK, NY, US, vol. 44, no. 9, 1 September 1996 (1996-09-01), pages 706-720, XP000699724 ISSN: 1549-4950

## Description

### BACKGROUND OF THE INVENTION

### Field of the Invention

This invention relates to lossless audio codecs and more specifically to a scalable lossless audio codec.

### Description of the Related Art

Numbers of low bit-rate lossy audio coding systems are currently in use in a wide range of consumer and professional audio playback products and services. For example, Dolby AC3 (Dolby digital) audio coding system is a world-wide standard for encoding stereo and 5.1 channel audio sound tracks for Laser Disc, NTSC coded DVD video, and ATV, using bit rates up to 640kbit/s. MPEG I and MPEG II audio coding standards are widely used for stereo and multi-channel sound track encoding for PAL encoded DVD video, terrestrial digital radio broadcasting in Europe and Satellite broadcasting in the US, at bit rates up to 768kbit/s. DTS (Dig ital Theater Systems) Coherent Acoustics audio coding system is frequently used for studio quality 5.1 channel audio sound tracks for Compact Disc, DVD video, Satellite Broadcast in Europe and Laser Disc and bit rates up to 1536kbit/s.

An improved codec offering 96 kHz bandwidth and 24 bit resolution is disclosed in U.S. patent No. 6,226,616 (also assigned to Digital Theater Systems, Inc.). That patent employs a core and extension methodology in which the traditional audio coding algorithm constitutes the 'core' audio coder, and remains unaltered. The audio data necessary to represent higher audio frequencies (in the case of higher sampling rates) or higher sample resolution (in the case of larger word lengths), or both, is transmitted as an 'extension' stream. This allows audio content providers to include a single audio bit stream that is compatible with different types of decoders resident in the consumer equipment base. The core stream will be decoded by the older decoders which will ignore the extension data, while newer decoders will make use of both core and extension data streams giving higher quality sound reproduction. However, this prior approach does not provide truly lossless encoding or decoding. Although the system of U.S. patent 6,226,216 provides superior quality audio playback, it does not provide "lossless" performance.

Recently, many consumers have shown interest in these so-called "lossless" codecs. "Lossless" codecs rely on algorithms which compress data without discarding any information. As such, they do not employ psychoacoustic effects such as "masking". A lossless codec produces a decoded signal which is identical to the (digitized) source signal. This performance comes at a cost: such codecs typically require more bandwidth than lossy codecs, and compress the data to a lesser degree.

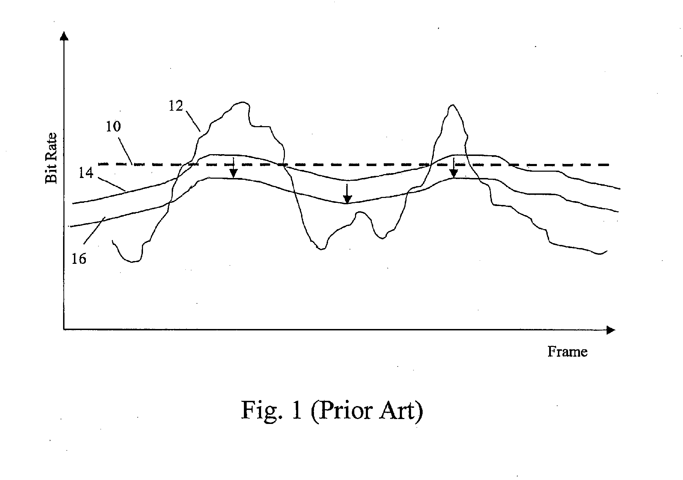

The lack of compression can cause a problem when content is being authored to a disk, CD, DVD, etc., particularly in cases of highly un-correlated source material or very large source bandwidth requirements. The optical properties of the media establish a peak bit rate for all content that can not be exceeded. As shown in Figure 1, a hard threshold **10**, e.g., 9.6 Mbps for DVD audio, is typically established for audio so that the total bit rate does not exceed the media limit.

The audio and other data is laid out on the disk to satisfy the various media constraints and to ensure that all the data that is required to decode a given frame will be present in the audio decoder buffer. The buffer has the effect of smoothing the frame-to-frame encoded payload (bit rate) 12, which can fluctuate wildly from frame-to-frame, to create a buffered payload 14, i.e. the buffered average of the frame-to-frame encoded payload. If the buffered payload 14 of the lossless bitstream for a given channel exceeds the threshold at any point the audio input files are altered to reduce their information content. The audio files may be altered by reducing the bit-depth of one or more channels such as from 24-bit to 22-bit, filtering a channel's frequency bandwidth to low-pass only, or reducing the audio bandwidth such as by filtering information above 40 kHz when sampling at 96 kHz. The altered audio input files are re-encoded so that the payload 16 never exceeds the threshold 10. An example of this process is described in the SurCode MLP - Owner's Manual pp. 20-23.

This is a very computationally and time inefficient process. Furthermore, although the audio encoder is still lossless, the amount of audio content that is delivered to the user has been reduced over the entire bitstream. Moreover, the alteration process is inexact, if too little information is removed the problem may still exist, if too much information is removed audio data is needlessly discarded. In addition, the authoring process will have to be tailored to the specific optical properties of the media and the buffer size of the decoder.

US2003/0179938A1 describes a technique for generating a compressed signal by splitting a unit of two or more bits into an MSB and an LSB part where only the MSB part is compressed in a lossless fashion, and combined with the compressed LSB to form the compressed signal.

### SUMMARY OF THE INVENTION

In a first aspect the present invention provides a method of encoding a scalable, lossless bitstream for M-bit PCM audio samples for decoding by a backward compatible lossless decoder, comprising: encoding the M-bit PCM audio samples into a lossy M-bit corestream; packing the lossy M-bit corestream into a bitstream; decoding the M-bit corestream into a reconstructed core signal; separating the M-bit PCM audio samples into M-N bit MSB and N-bit LSB portions; packing the N-bit LSB portion into the bitstream; right shifting the reconstructed core signal by N bits to align it with the MSB portion; subtracting the reconstructed core signal from the MSB portion to form an M-N bit difference signal; losslessly encoding the difference signal; packing the encoded difference signal into the bitstream; and packing the bit widths of the LSB portions into the lossless bitstream

In a second aspect the present invention provides a method of decoding a bitstream for M-bit PCM audio samples, the bitstream comprising a corestream, an N-bit least significant bit (LSB) extension stream and a M-N bit most significant bit (MSB) extension stream, the method comprising: unpacking the bitstream, the unpacking including separating the corestream from the MSB extension stream and the LSB extension stream; decoding the corestream into a lossy M-bit PCM decoded corestream using a core decoder; decoding the MSB extension stream into a lossless decoded MSB extension stream using a lossless MSB decoder; right-shifting the decoded corestream by N bits to produce a right-shifted decoded corestream; combining the right-shifted decoded corestream with the decoded MSB extension stream to produce a summed output; left-shifting the summed output by N bits to produce a left-shifted summed output; and combining the left-shifted summed output with the LSB extension stream to form a lossless reconstruction of the original M-bit PCM audio signal.

In a third aspect the present invention provides an encoder configured to encode a scalable, lossless bitstream for M-bit PCM audio samples for decoding by a backward compatible lossless decoder, comprising: a core encoder configured to encode the M-bit PCM audio samples into a lossy M-bit corestream; a packer configured to pack the lossy M-bit corestream into a bitstream; a core decoder configured to decode the M-bit corestream into a reconstructed core signal; means for separating the M-bit PCM audio samples into M-N bit MSB and N-bit LSB portions; means for right-shifting the reconstructed core signal by N bits to align it with the MSB portion; a subtracting node configured to subtract the reconstructed core signal from the MSB portion to form an M-N bit difference signal; and a lossless encoder configured to losslessly encode the difference signal; wherein the packer is further configured to: pack the N-bit LSB portion into the bitstream; pack the encoded difference signal into the bitstream; and pack the bit widths of the LSB portions into the bitstream.

In a fourth aspect the present invention provides a decoder configured to decode a bitstream for M-bit PCM audio samples, the bitstream comprising a corestream, an N-bit least significant bit (LSB) extension stream and a M-N bit most significant bit (MSB) extension stream, the decoder comprising: an unpacker configured to unpack the bitstream and to separate the corestream from the MSB extension stream and the LSB extension stream; a core decoder configured to decode the corestream into a lossy M-bit PCM decoded corestream; an MSB decoder configured to decode the MSB extension stream into a lossless decoded MSB extension stream; means for right-shifting the decoded corestream by N bits to produce a right-shifted decoded corestream; a summer configured to combine the right-shifted decoded corestream with the decoded MSB extension stream to produce a summed output; means for left-shifting the summed output by N bits to produce a left-shifted summed output; means for combining the left-shifted summed output with the MSB extension stream to form a lossless reconstruction of the original M-bit PCM audio signal.

These and other features and advantages of the invention will be apparent to those skilled in the art from the following detailed description of preferred embodiments, taken together with the accompanying drawings, in which:

### BRIEF DESCRIPTION OF THE DRAWINGS

FIG. 1, as described above, is a plot of bit rate and payload for a lossless audio channel versus time;
FIG. 2 is a block diagram of a lossless audio codec and authoring tool useful for understanding the present invention;
FIG. 3 is a simplified flowchart of the audio coder;
FIG. 4 is a diagram of an MSB/LSB split for a sample in the lossless bitstream;
FIG. 5 is a simplified flowchart of the authoring tool;
FIG. 6 is a diagram of an MSB/LSB split for a sample in the authored bitstreams;
FIG. 7 is a diagram of a bitstream including the MSB and LSB portions and header information;
FIG. 8 is a plot of payload for the lossless and authored bitstreams;
FIG. 9 is a simple block diagram of an audio decoder;
FIG. 10 is a flowchart of the decoding process;
FIG. 11 is a diagram of an assembled bitstream;
FIGs. 12-15 illustrate the bitstream format, encoding, authoring, and decoding; and
FIGs . 16a and 16b are block diagrams of the encoder and decoder for a scalable lossless codec according to embodiments of the invention that is backwards compatible with a lossy core encoder.

### DETAILED DESCRIPTION OF THE INVENTION

The following discusses a lossless audio codec and authoring tool for selectively discarding bits to satisfy media, channel, decoder buffer or playback device bit rate constraints without having to filter the audio input files, reencode or to otherwise disrupt the lossless bitstream.

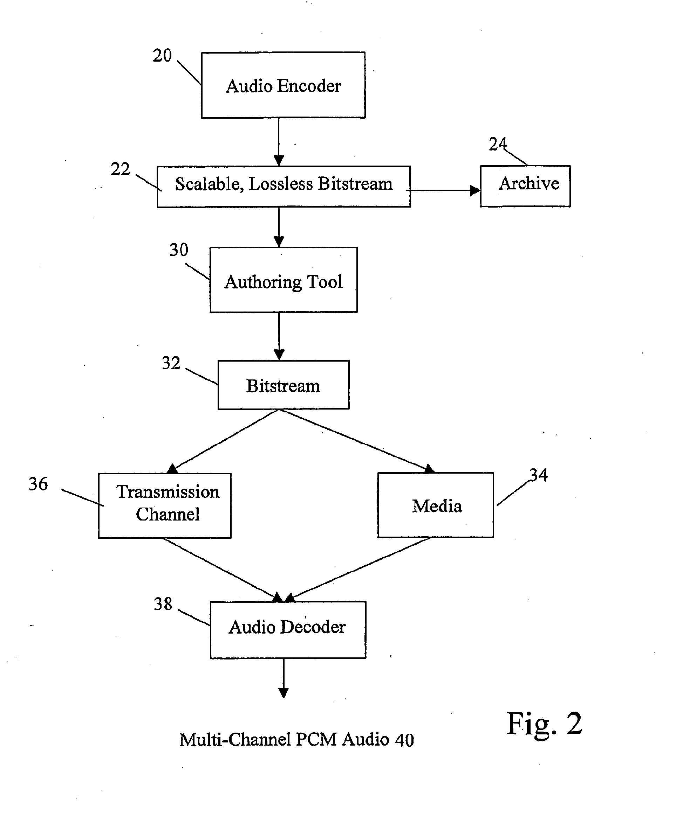

As shown in Figure 2, an audio encoder **20** losslessly encodes the audio data in a sequence of analysis windows and packs the encoded data and header information into a scalable, lossless bitstream **22,** which is suitably stored in an archive **24.** The analysis windows are typically frames of encoded data but as used herein the windows could span a plurality of frames. Furthermore, the analysis window may be refined into one or more segments of data inside a frame, one or more channel sets inside a segment, one or more channels in each channel set and finally one or more frequency extensions inside a channel. The scaling decisions for the bitstream can be very coarse (multiple frames) or more refined (per frequency extension per channel set per frame).

An authoring tool **30** is used to lay out the encoded data on a disk (media) in accordance with the decoder's buffer capacity. The initial layout corresponds to the buffered payload. The tool compares the buffered payload to the allowed payload for each analysis window to determine whether the layout requires any modification. The allowed payload is typically a function of the peak bit rate supported by a media (DVD disk) or transmission channel. The allowed payload may be fixed or allowed to vary if part of a global optimization. The authoring tool selectively scales the losslessly encoded audio data in the non-conforming windows to reduce the encoded payload, hence the buffered payload. The scaling process introduces some loss into the encoded data but is confined to only the non-conforming windows and is suitably just enough to bring each window into conformance. The authoring tool packs the lossless and lossy data and any modified header information into a bitstream **32.** The bitstream **32** is typically stored on a media **34** or transmitted over a transmission channel **36** for subsequent playback via an audio decoder **38,** which generates a single or multi-channel PCM (pulse code modulated) audio stream **40.**

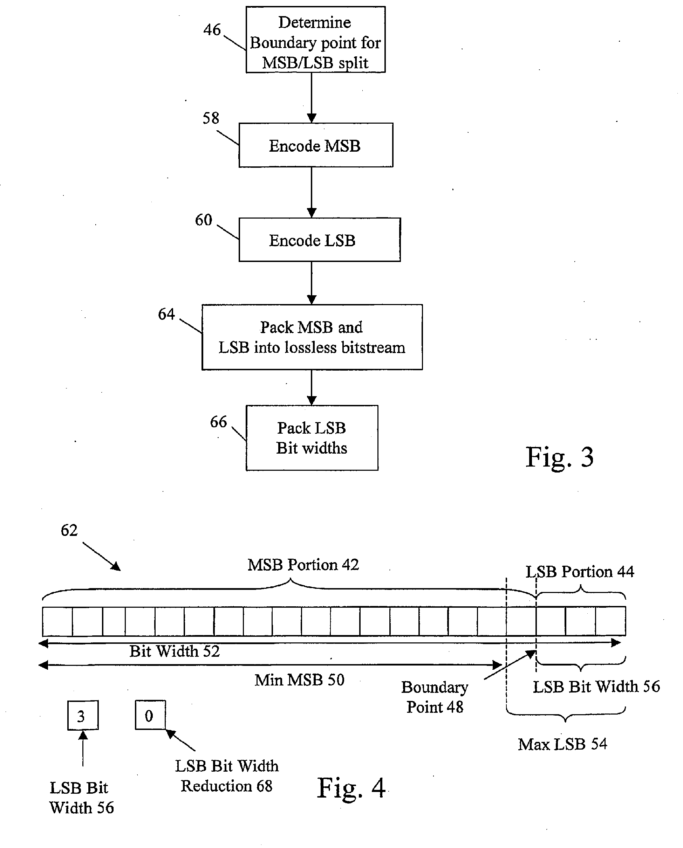

In an exemplary embodiment as shown in Figures 3 and 4, the audio encoder **20** splits each audio sample into a MSB portion **42** and a LSB portion **44** (step **46**). The boundary point **48** that separates the audio data is computed by first assigning a minimum MSB bit width (Min MSB) **50** that establishes a minimum coding level for each audio sample. For example, if the bit width **52** of the audio data is 20-bit the Min MSB might be 16-bit. It follows that the maximum LSB bit width (Max LSB) **54** is the Bit Width **52** minus the Min MSB **50.** The encoder computes a cost function, e.g. the L₂ or L_{∞} norms, for the audio data in the analysis window. If the cost function exceeds a threshold, the encoder calculates an LSB bit width **56** of at least one bit and no more than Max LSB. If the cost function does not exceed the threshold, the LSB bit width **56** is set to zero bits. In general, the MSB/LSB split is done for each analysis window. As describe above, this is typically one or more frames. The split can be further refined for each data segment, channel set, channel or frequency extension, for example. More refinement improves coding performance at the cost of additional computations and more overhead in the bitstream.

The encoder losslessly encodes the MSB portions (step **58**) and LSB portions (step **60**) with different lossless algorithms. The audio data in the MSB portions is typically highly correlated both temporally within any one channel and between channels. Therefore, the lossless algorithm suitably employs entropy coding, fixed prediction, adaptive prediction and joint channel decorrelation techniques to efficiently code the MSB portions. A suitable lossless encoder is described in copending application "Lossless Multi-Channel Audio Codec" filed on August 08, 2004, US 2004 0911067. Other suitable lossless encoders include MLP (DVD Audio), Monkey's audio (computer applications), Apple lossless, Windows Media Pro lossless, AudioPak, DVD, LTAC, MUSICcompress, OggSquish, Philips, Shorten, Sonarc and WA. A review of many of these codecs is provided by Mat Hans, Ronald Schafer "Lossless Compression of Digital Audio" Hewlett Packard, 1999.

Conversely, the audio data in the LSB portion is highly uncorrelated, closer to noise. Therefore sophisticated compression techniques are largely ineffective and consume processing resources. Furthermore, to efficiently author the bitstream, a very simple lossless code using simplistic prediction of very low order followed by a simple entropy coder is highly desirable. In fact, the currently preferred algorithm is to encode the LSB portion by simply replicating the LSB bits as is. This will allow individual LSBs to be discarded without having to decode the LSB portion.

The encoder separately packs the encoded MSB and LSB portions into a scalable, lossless bitstream **62** so that they can be readily unpacked and decoded (step **64**). In addition to the normal header information, the encoder packs the LSB bit width **56** into the header (step **66**). The header also includes space for an LSB bit width reduction **68,** which is not used during encode. This process is repeated for each analysis window (frames, frame, segment, channel set or frequency extension) for which the split is recalculated.

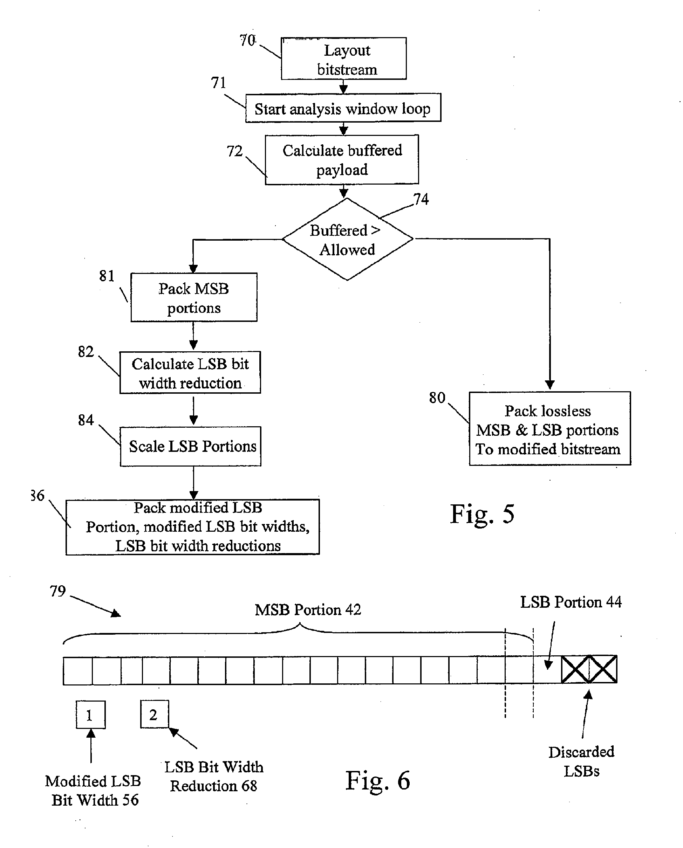

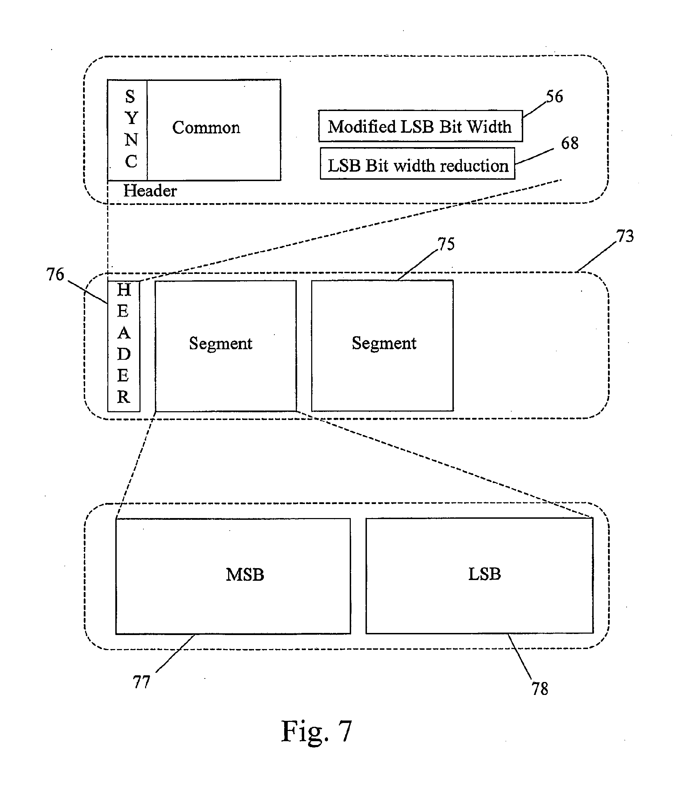

As shown in Figures 5, 6 and 7, the authoring tool **30** allows a user to make a first pass at laying out the audio and video bitstreams on the media in accordance with the decoder's buffer capacity (step **70**) to satisfy the media's peak bit rate constraint. The authoring tool starts the analysis window loop (step **71**), calculates an buffered payload (step **72**) and compares the buffered payload to the allowed payload for the analysis window **73** to determine whether the lossless bitstream requires any scaling to satisfy the constraints (step **74**). The allowed payload is determined by buffer capacity of the audio decoder and the peak bit rate of the media or channel. The encoded payload is determined by the bit width of the audio data and the number of samples in all of the data segments **75** plus the header **76.** If the allowed payload is not exceeded, the losslessly encoded MSB and LSB portions are packed into respective MSB and LSB areas **77** and **78** of the data segments **75** in a modified bitstream **79** (step **80**). If the allowed payload is never exceeded, the lossless bitstream is transferred directly to the media or channel.

If the buffered payload exceeds the allowed payload, the authoring tool packs the headers and losslessly encoded MSB portions **42** into the modified bitstream **79** (step **81**). Based on a prioritization rule, the authoring tool calculates an LSB bit width reduction **68** that will reduce the encoded payload, hence buffered payload to at most the allowed payload (step **82**). Assuming the LSB portions were simply replicated during lossless encoding, the authoring tool scales the LSB portions (step **84**) by preferably adding dither to each LSB portion so as to dither the next LSB bit past the LSB bit width reduction, and then shifting the LSB portion to the right by the LSB bit width reduction to discard bits. If the LSB portions were encoded, they would have to be decoded, dithered, shifted and reencoded. The tool packs the now lossy encoded LSB portions for the now conforming windows into the bitstream with the modified LSB bit widths **56** and the LSB bit width reduction **68** and a dither parameter (step **86**).

As shown in Figure 6, the LSB portion **44** has been scaled from a bit width of 3 to a modified LSB bit width **56** of 1-bit. The two discarded LSBs **88** match the LSB bit width reduction **68** of 2 bits. In the exemplary embodiment, the modified LSB bit width **56** and LSB bit width reduction **68** are transmitted in the header to the decoder. Alternately, either of these could be omitted and the original LSB bit width transmitted. Any one of the parameters is uniquely determined by the other two.

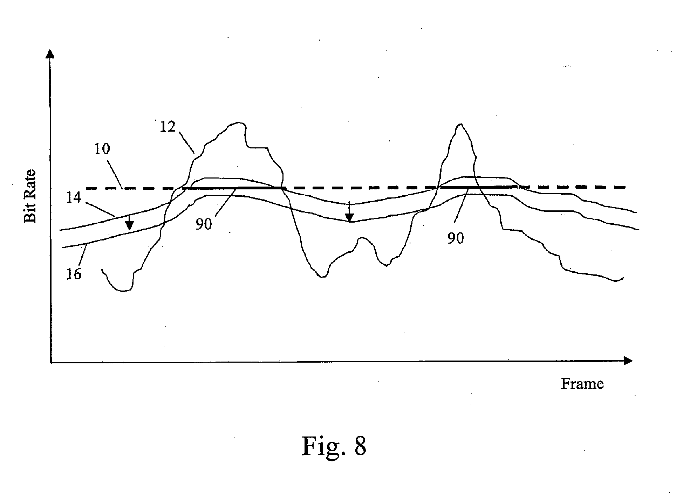

The benefits of the scalable, lossless encoder and authoring tool are best illustrated by overlaying the buffered payload **90** for the authored bitstream on Figure 1 as is done in Figure 8. Using the known approach of altering the audio files to remove content and then simply reencoding with the lossless coder, the buffered payload **14** was effectively shifted downward to a buffered payload **16** that is less than the allowed payload **10.** To ensure that the peak payload is less than the allowed payload, a considerable amount of content is sacrificed across the entire bitstream. By comparison, the buffered payload **90** replicates the original losslessly buffered payload **14** except in those few windows (frames) where the buffered payload exceeds the allowed payload. In these areas, the encoded payload, hence buffered payload is reduced just enough to satisfy the constraint and preferably no more. As a result, the payload capacity is utilized more efficiently and more content is delivered to the end user without having to alter the original audio files or reencode.

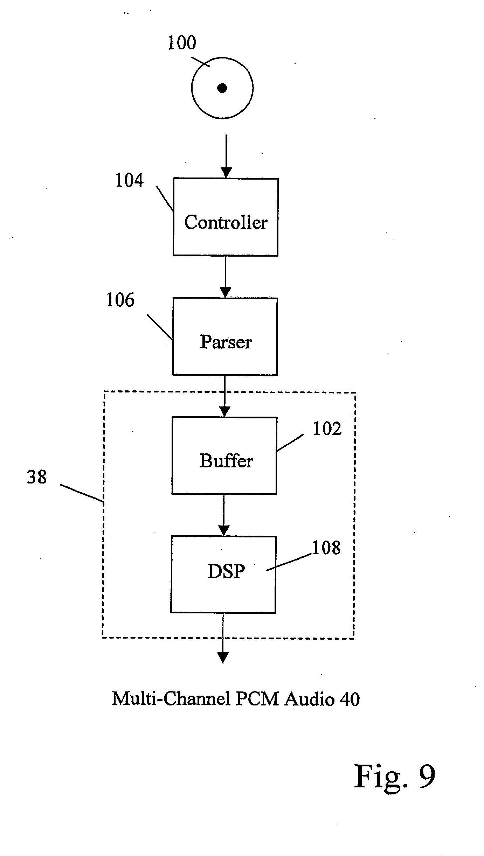

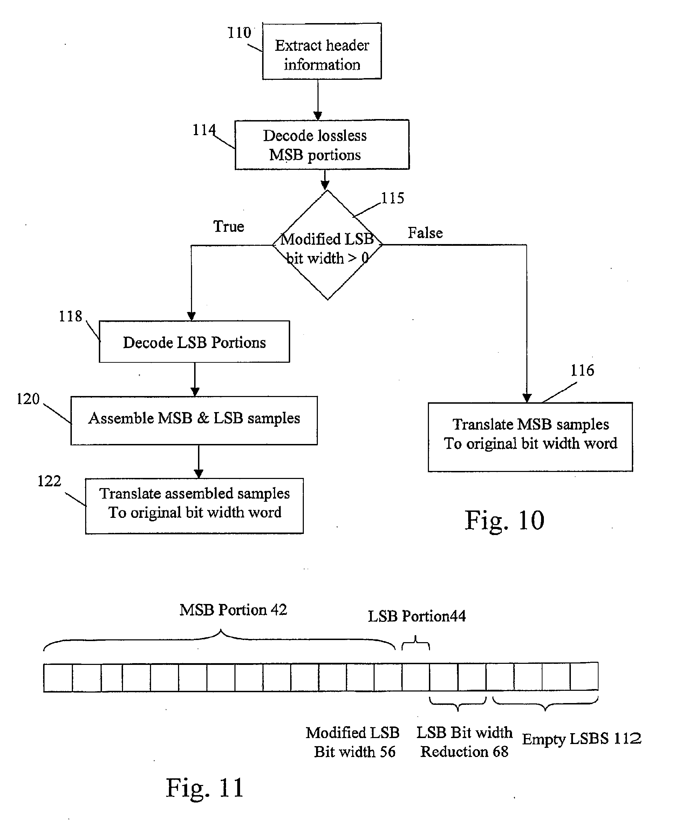

As shown in Figures 9, 10 and 11, the audio decoder **38** receives an authored bitstream via a disk **100.** The bitstream is separated into a sequence of analysis windows, each including header information and encoded audio data. Most of the windows include losslessly encoded MSB and LSB portions, the original LSB bit widths and LSB bit width reductions of zero. To satisfy the payload constraints set by the peak bit rate of the disk **100** and the capacity of the buffer **102,** some of the windows include the losslessly encoded MSB portions and lossy LSB portions, the modified bit widths of the lossy LSB portions, and the LSB bit width reductions.

A controller **104** reads the encoded audio data from the bitstream on the disk **100.** A parser **106** separates the audio data from the video and streams the audio data to the audio buffer **102,** which does not overflow on account of the authoring. The buffer in turn provides sufficient data to a DSP chip **108** to decode the audio data for the current analysis window. The DSP chip extracts the header information (step **110**) including the modified LSB bit widths **56,** LSB bit width reduction **68,** a number of empty LSBs **112** from an original word width and extracts, decodes and assembles the MSB portions of the audio data (step **114**). If all of the LSBs were discarded during authoring or original LSB bit width was 0 (step **115**), the DSP chip translates the MSB samples to the original bit width word and outputs the PCM data (step **116**). Otherwise, the DSP chip decodes the lossless and lossy LSB portions (step **118**), assembles the MSB & LSB samples (step **120**), and, using the header information, translates the assembled samples to the original bit width word (step **122**).

### Multi-Channel Audio Codec & Authoring Tool

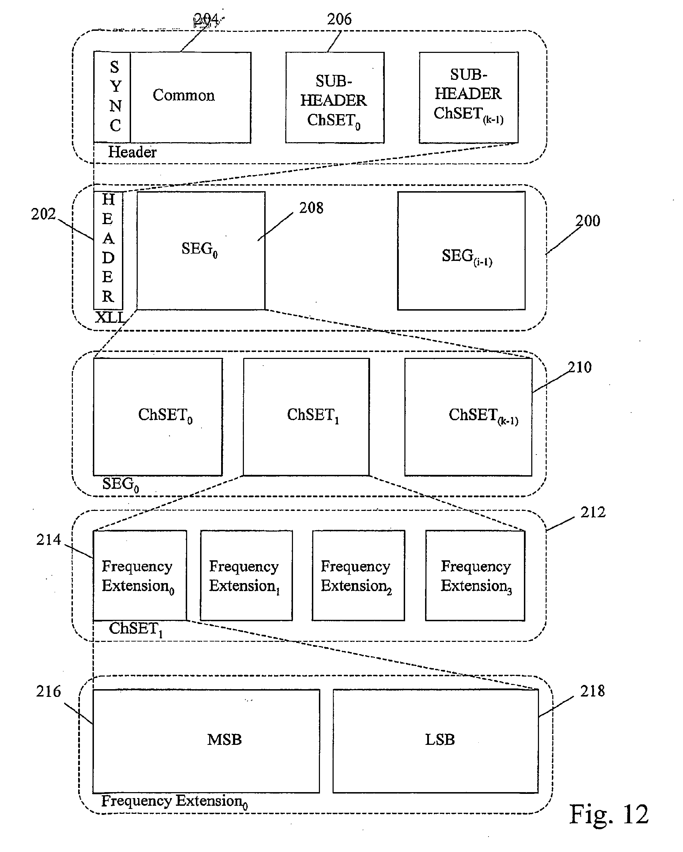

An exemplary embodiment of an audio codec and authoring tool for an encoded audio bitstream presented as a sequence of frames is illustrated in Figures 12-15. As shown in Figure 12, each frame **200** comprises a header **202** for storing common information **204** and sub-headers **206** for each channel set that store the LSB bit widths and LSB bit width reductions, and one or more data segments **208.** Each data segment comprises one or more channel sets **210** with each channel set comprising one or more audio channels **212.** Each channel comprises one or more frequency extensions **214** with at least the lowest frequency extension including encoded MSB and LSB portions **216, 218.** The bitstream has a distinct MSB and LSB split for each channel in each channel set in each frame. The higher frequency extensions may be similarly split or entirely encoded as LSB portions.

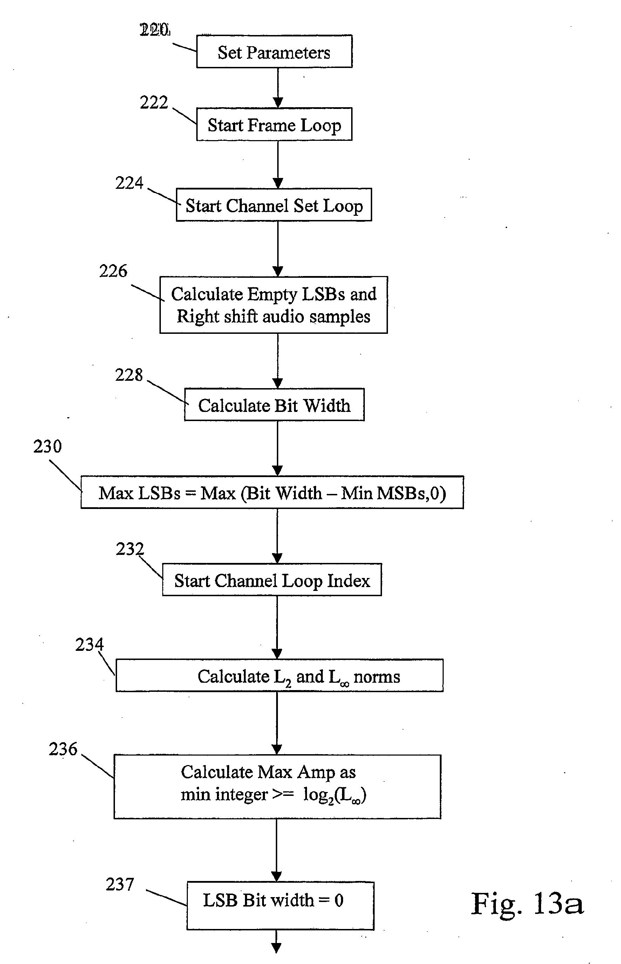

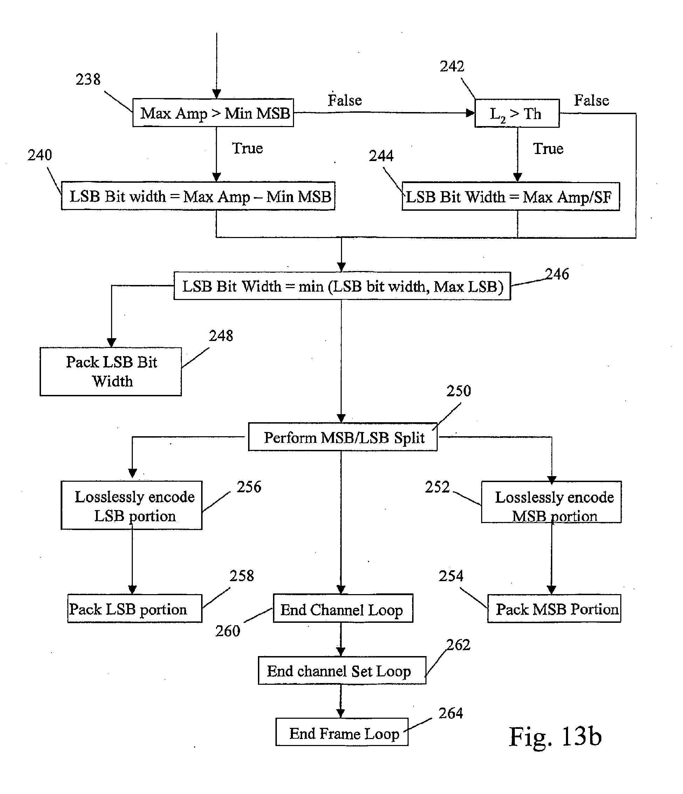

The scalable lossless bitstream from which this bitstream is authored is encoded as illustrated in Figures 13a and 13b. The encoder sets the bit width of the original word (24-bit), the Min MSB (16-bit), a threshold (Th) for the squared L2 norm and a scale factor (SF) for that norm (step **220**). The encoder starts the frame loop (step **222**) and the channel set loop (step **224**). Because the actual width of the audio data (20-bit) may be less than the original word width, the encoder calculates the number of empty LSBs (24-20=4)(min number of "0" LSBs in any PCM sample in the current frame) and right shifts every sample by that amount (step **226**). The bit width of the data is the original bit width (24) minus the number of empty LSBs (4) (step **228**). The encoder then determines the maximum number of bits (Max LSBs) that will allow to be encoded as part of the LSB portion as Max(Bit Width- Min MSB, 0) (step **230**). In the current example, the Max LSBS = 20- 16 = 4 bits.

To determine the boundary point for splitting the audio data into MSB and LSB portions, the encoder starts the channel loop index (step **232**) and calculates the L_{∞} norm as the maximum absolute amplitude of the audio data in the channel and the squared L2 norm as the sum of the squared amplitudes of the audio data in the analysis window (step **234**). The encoder sets a parameter Max Amp as the minimum integer greater than or equal to log₂(L_{∞}) (step **236**) and initializes the LSB bit width to zero (step **237**). If the Max Amp is greater than the Min MSB (step **238**), the LSB bit width is set equal to the difference of the Max Amp and Min MSB (step **240**). Otherwise, if the L2 norm exceeds the Threshold (small amplitude but considerable variance) (step **242**), the LSB bit width is set equal to the Max Amp divided by the Scale Factor, typically > 1 (step **244**). If both tests are false, the LSB bit width remains zero. In other words, to maintain the minimum encode quality, e.g. Min MSB, no LSBs are available. The encoder clips the LSB bit width at the Max LSB value (step **246**) and packs the value into the sub-header channel set (step **248**).

Once the boundary point has been determined, i.e. the LSB bit width, the encoder splits the audio data into the MSB and LSB portions (step **250**). The MSB portion is losslessly encoded using a suitable algorithm (step **252**) and packed into the lowest frequency extension in the particular channel in the channel set of the current frame (step **254**). The LSB portion is losslessly encoded using a suitable algorithm, e.g. simple bit replication (step **256**) and packed (step **258**).

This process is repeated for each channel (step **260**) for each channel set (step **262**) for each frame (step **264**) in the bitstream. Furthermore, the same procedure may be repeated for higher frequency extensions. However, because these extensions contain much less information, the Min MSB may be set to 0 so that it is all encoded as LSBs.

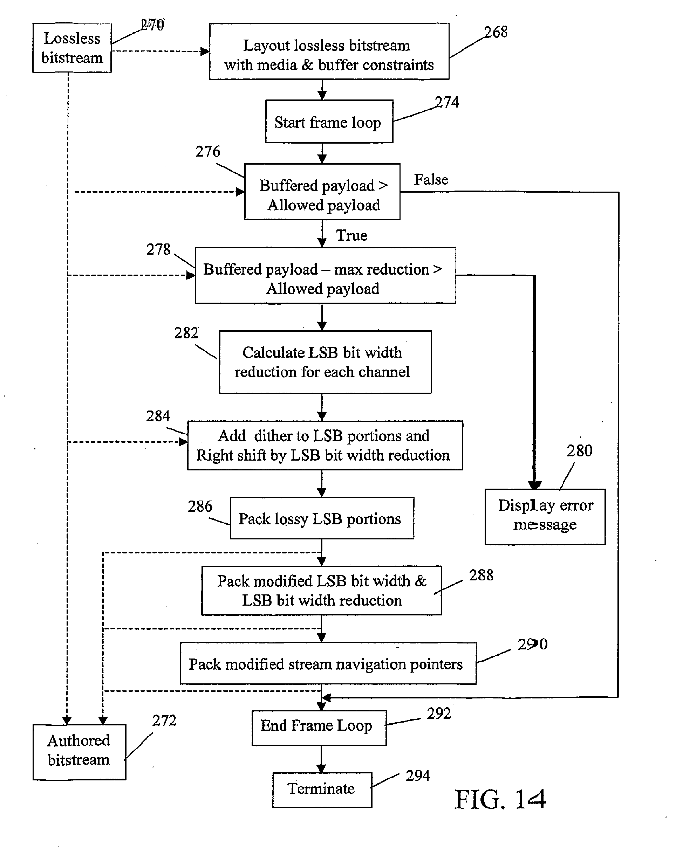

Once the scalable lossless bitstream is encoded for certain audio content, an authoring tool creates the best bitstream it can that satisfies the peak bit rate constraints of the transport media and the capacity of the buffer in the audio decoder. As shown in Figure 14, a user attempts to layout the lossless bitstream **268** on the media to conform to the bit rate and buffer capacity constrains (step **270**). If successful, the lossless bitstream **268** is written out as the authored bitstream **272** and stored on the media. Otherwise the authoring tool starts the frame loop (step **274**) and compares the buffered payload (buffered average frame-to-frame payload) to the allowed payload (peak bit rate) (step **276**). If the current frame conforms to the allowed payload, the losslessly encoded MSB and LSB portions are extracted from the lossless bitstream **268** and written to the authored bitstream **272** and the frame is incremented.

If the authoring tool encounters a non-conforming frame in which the buffered payload exceeds the allowed payload, the tool computes the maximum reduction that can be achieved by discarding all of the LSB portions in the channel set and subtracts it from the buffered payload (step **278**). If the minimum payload is still too big the tool displays an error message that includes the amount of excess date and frame number (step **280**). In this case either the Min MSB shall be reduced or the original audio files shall be altered and re-encoded.

Otherwise, the authoring tool calculates an LSB bit width reduction for each channel in the current frame based on a specified channel prioritization rule (step **282**) such that:
Bit Width Reduction[nCh] < LSB bit width[nCh] for nCh = 0, ... AllChannels -1, and
Buffered payload[nFr] - Σ (Bit Width Reduction[nCh} * NumSamplesin Frame) < Allowed Payload [nFr]

The reduction of the LSB bit widths by these values will ensure that the frame conforms to the allowed payload. This is done with a minimum amount of loss being introduced into the non-conforming frames and without otherwise affecting the lossless conforming frames.

The authoring tool adjusts the encoded LSB portions (assuming bit replication encoding) for each channel by adding dither to each LSB portion in the frame to dither the next bit and then right shifting by the LSB bit width reduction (step **284**). Adding dither is not necessary but is, highly desirable in order to decorrelate the quantization errors and also make them decorrelated from the original audio signal. The tool packs the now lossy scaled LSB portions (step **286**), the modified LSB bit widths and LSB bit width reductions for each channel (step **288**) and the modified stream navigation points (step **290**) into the authored bitstream. If dither is added, a dither parameter is packed into the bitstream. This process is then repeated for each frame (step **292**) before terminating (step **294**).

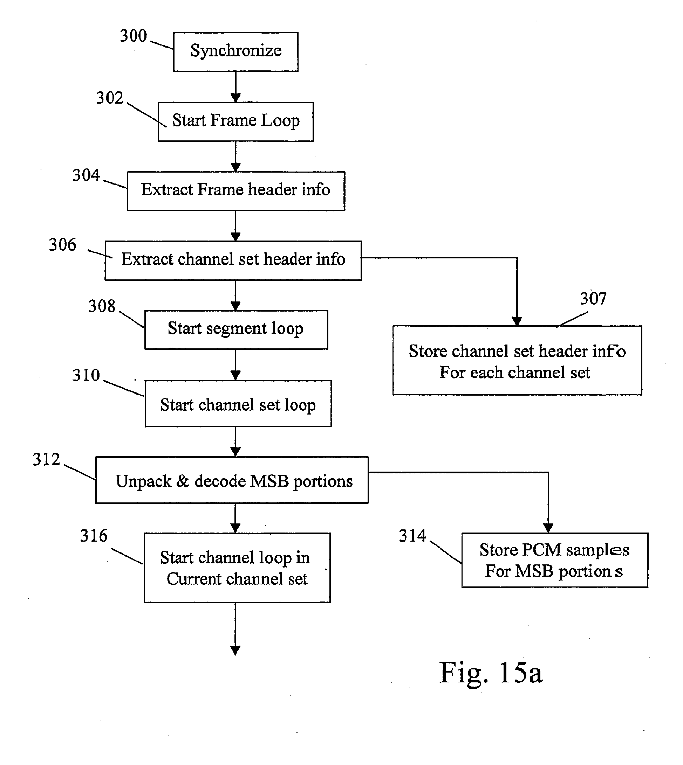

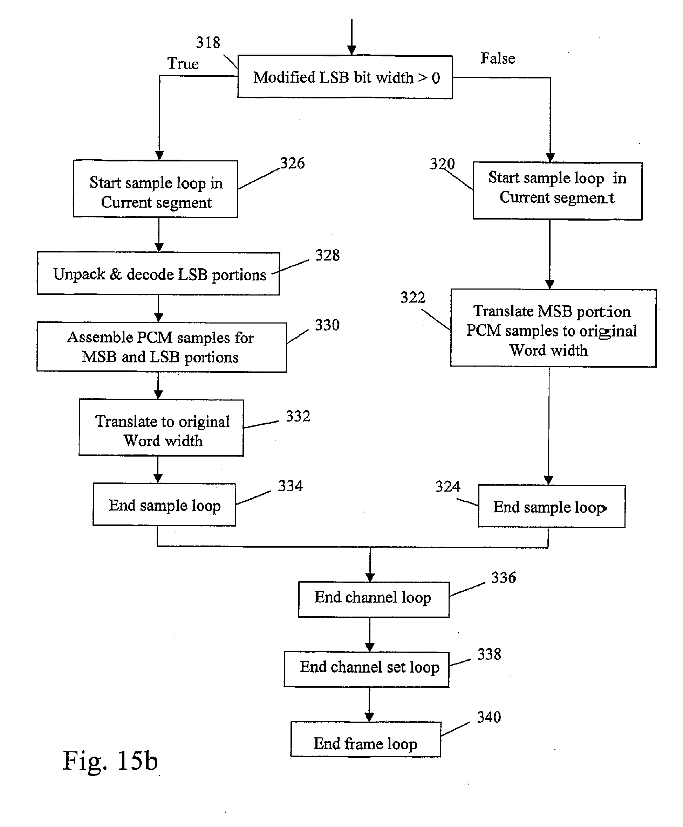

As shown in Figures 15a and 15b, a suitable decoder synchronizes to the bitstream (step **300**) and starts a frame loop (step **302**). The decoder extracts the frame header in formation including the number of segments, number of samples in a segment, number of channel sets, etc (step **304**) and extracts the channel set header information including the number channels in the set, number of empty LSBs, LSB bit width, LSB bit width reduction for each channel set (step **306**) and stores it for each channel set (step **307**).

Once the header information is available, the decoder starts the segment loop (step **308**) and channel set loop (step **310**) for the current frame. The decoder unpacks and decodes the MSB portions (step **312**) and stores the PCM samples (step **314**). The decoder then starts the channel loop in the current channel set (step **316**) and proceeds with the encoded LSB data.

If the modified LSB bit width does not exceed zero (step **318**), the decoder starts the sample loop in the current segment (step **320**), translates the PCM samples for the MSB portion to the original word width (step **322**) and repeats until the sample loop terminates (step **324**).

Otherwise, the decoder starts the sample loop in the current segment (step **326**), unpacks and decodes the LSB portions (step **328**) and assembles PCM samples by appending the LSB portion to the MSB portion (step **330**). The decoder then translates the PCM sample to the original word width using the empty LSB, modified LSB bit width and LSB bit width reduction information from the header (step **332**) and repeats the steps until the sample loop terminates (step **334**). To reconstruct the entire audio sequence, the decoder repeats these steps for each channel (step **336**) in each channel set (step **338**) in each frame (step **340**).

### Backward Compatible Scalable Audio Codec

The scalability properties can be incorporated into a backward compatible lossless encoder, bitstream format and decoder. A "lossy" core code stream is packed in concert with the losslessly encoded MSB and LSB portions of the audio data for transmission (or recording). Upon decoding in a decoder with extended lossless features, the lossy and lossless MSB streams are combined and the LSB stream is appended to construct a lossless reconstructed signal. In a prior-generation decoder, the lossless MSB and LSB extension streams are ignored, and the core "lossy" stream is decoded to provide a high-quality, multichannel audio signal with the bandwidth and signal-to-noise ratio characteristic of the core stream.

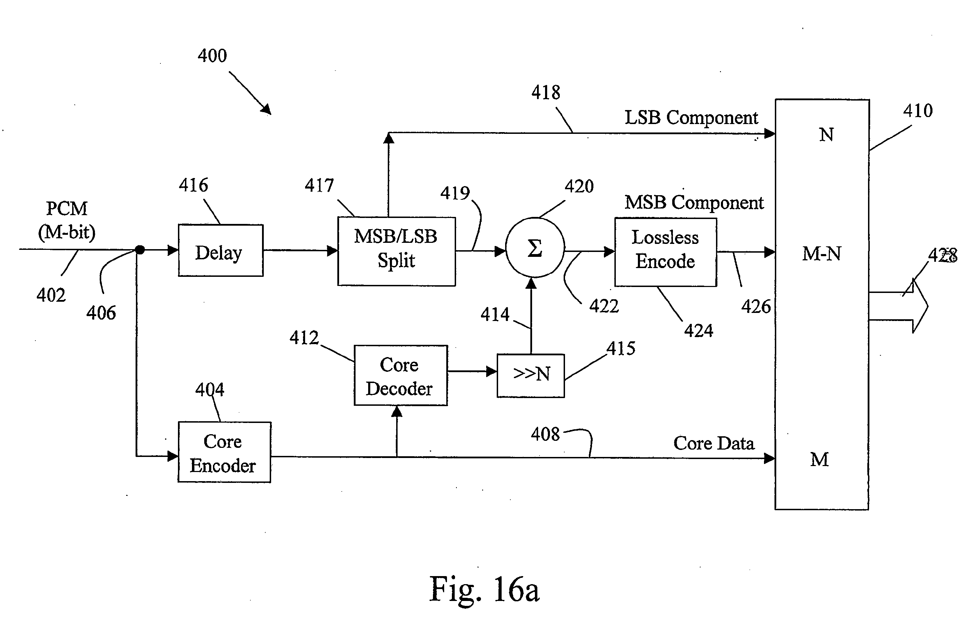

Figure 16a shows a system level view of a scalable backward compatible encoder **400**. A digitized audio signal, suitably M-bit PCM audio samples, is provided at input **402**. Preferably, the digitized audio signal has a sampling rate and bandwidth which exceeds that of a modified, lossy core encoder **404**. In one embodiment, the sampling rate of the digitized audio signal is 96 kHz (corresponding to a bandwidth of 48 kHz for the sampled audio). It should also be understood that the input audio may be, and preferably is, a multichannel signal wherein each channel is sampled at 96 kHz. The discussion which follows will concentrate on the processing of a single channel, but the extension to multiple channels is straightforward. The input signal is duplicated at node **406** and handled in parallel branches. In a first branch of the signal path, a modified lossy, wideband encoder **404** encodes the signal. The modified core encoder **404,** which is described in detail below, produces an encoded data stream (corestream **408**) which is conveyed to a packer or multiplexer **410.** The corestream **408** is also communicated to a modified corestream decoder **412**, which produces as output a modified, reconstructed core signal **414,** which is right shifted by N bits (>>N **415**) to discard its N lsbs.

Meanwhile, the input digitized audio signal **402** in the parallel path undergoes a compensating delay **416,** substantially equal to the delay introduced into the reconstructed audio stream (by modified encode and modified decoders), to produce a delayed digitized audio stream. The audio stream is split into MSB and LSB portions **417** as described above. The N-bit LSB portion **418** is conveyed to the packer **410.** The M-N bit reconstructed core signal **414,** which was shifted to align with the MSB portion, is subtracted from the MSB portion of the delayed digitized audio stream **419** at subtracting node **420.** (Note that a summing node could be substituted for a subtracting node, by changing the polarity of one of the inputs. Thus, summing and subtracting may be substantially equivalent for this purpose).

Subtracting node **420** produces a difference signal **422** which represents the difference between the M-N MSBs of the original signal and the reconstructed core signal. To accomplish purely "lossless" encoding, it is necessary to encode and transmit the difference signal with lossless encoding techniques. Accordingly, the M-N bit difference signal **422** is encoded with a lossless encoder **424,** and the encoded M-N bit signal **426** packed or multiplexed with the core stream **408** in packer **410** to produce a multiplexed output bitstream **428.** Note that the lossless coding produced coded lossless streams **418** and **426** which are at a variable bit rate, to accommodate the needs of the lossless coder. The packed stream is then optionally subjected to further layers of coding including channel coding, and then transmitted or recorded. Note that for purposes of this disclosure, recording may be considered as transmission through a channel.

The core encoder **404** is described as "modified" because in an embodiment capable of handling extended bandwidth the core encoder would require modification. A 64-band analysis filter bank within the encoder discards half of its output data and encodes only the lower 32 frequency bands. This discarded information is of no concern to legacy decoders that would be unable to reconstruct the upper half of the signal spectrum in any case. The remaining information is encoded as per the unmodified encoder to form a backwards-compatible core output stream. However, in another embodiment operating at or below 48 kHz sampling rate, the core encoder could be a substantially unmodified version of a prior core encoder. Similarly, for operation above the sampling rate of legacy decoders, the core decoder **412** would need to be modified as described below. For operation at conventional sampling rate (e.g., 48 kHz and below) the core decoder could be a substantially unmodified version of a prior core decoder or equivalent. In some embodiments the choice of sampling rate could be made at the time of encoding, and the encode and decode modules reconfigured at that time by software as desired.

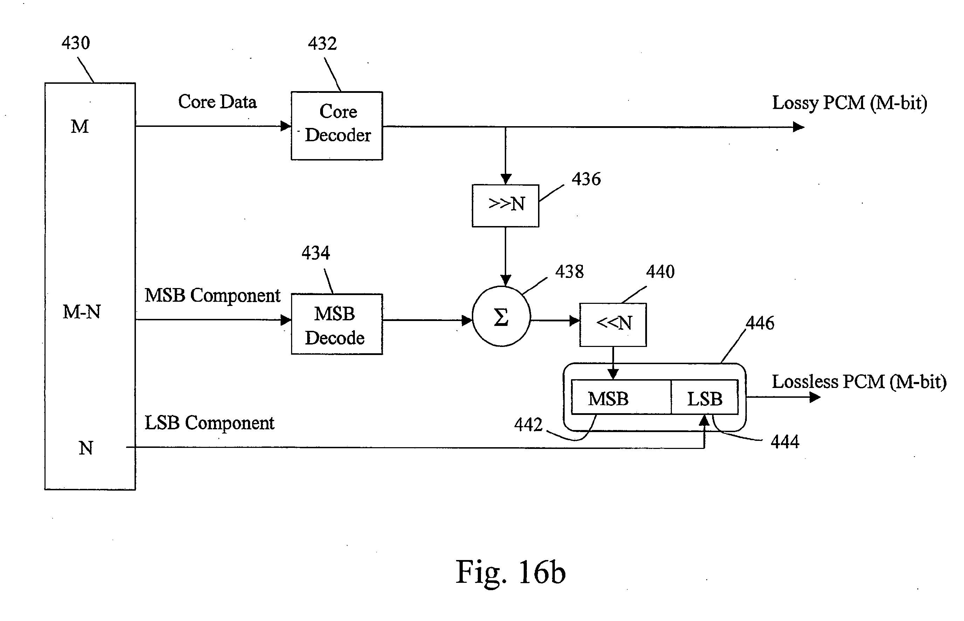

As shown in Figure 16b, the method of decoding is complementary to the method of encoding. A prio r generation decoder can decode the lossy core audio signal by simply decoding the corestream **408** and discarding the lossless MSB and LSB portions. The quality of audio produced in such a prior generation decoder will be extremely good, equivalent to prior generation audio, just not lossless.

Referring now to Figure 16b, the incoming bitstream (recovered from either a transmission channel or a recording medium) is first unpacked in unpacker **430,** which separates the corestream **408** from lossless extension data streams **418** (LSB) and **426** (MSB). The core stream is decoded by a modified core decoder **432,** which reconstructs the core stream by zeroing out the untransmitted sub-band samples for the upper 32 bands in a 64-band synthesis during reconstruction. (Note, if a standard core encode was performed, the zeroing out is unnecessary). The MSB extension field is decoded by a lossless MSB decoder **434.** Because the LSB data was losslessly encoded using bit replication no decoding is necessary.

After decoding core and lossless MSB extensions in parallel, with the interpolated core reconstructed data is right shifted by N bits **436** and combined with the lossless portion of the data by adding in summer **438.** The summed output is left shifted by N bits **440** to form the lossless MSB portion **442** and assembled with the N-bit LSB portion **444,** to produce a PCM data word **446** that is a lossless, reconstructed representation of the original audio signal **402.**

Because the signal was encoded by subtracting a decoded, lossy reconstruction from the exact input signal, the reconstructed signal represents an exact reconstruction of the original audio data. Thus, paradoxically, the combination of a lossy codec and a losslessly coded signal actually performs as a pure lossless codec, but with the additional advantage that the encoded data remains compatible with prior generation, lossless decoders. Furthermore, the bitstream can be scaled by selectively discarding LSBs to make it conform to media bit rate constraints and buffer capacity.

While seve ral illustrative embodiments of the invention have been shown and described, numerous variations and alternate embodiments will occur to those skilled in the art. Such variations and alternate embodiments are contemplated, and can be made without departing from the scope of the invention as defined in the appended claims.

## Claims

1. A method of encoding a scalable, lossless bitstream for M-bit PCM audio samples for decoding by a backward compatible lossless decoder, comprising:
encoding the M-bit PCM audio samples into a lossy M-bit corestream (408);
packing the lossy M-bit corestream into a bitstream;
decoding the M-bit corestream into a reconstructed core signal (414);
separating (417) the M-bit PCM audio samples into M-N bit MSB and N-bit LSB (418) portions;
packing the N-bit LSB portion into the bitstream;
right shifting (415) the reconstructed core signal by N bits to align it with the MSB portion;
subtracting (420) the reconstructed core signal from the MSB portion to form an M-N bit difference signal (422);
losslessly encoding the difference signal;
packing the encoded difference signal into the bitstream; and
packing the bit widths of the LSB portions into the lossless bitstream.

2. The method of claim 1, further comprising adding dither to the reconstructed core signal prior to right shifting and packing a dither parameter into the bitstream.

3. A method of decoding a bitstream for M-bit PCM audio samples, the bitstream comprising a corestream (408), an N-bit least significant bit (LSB) extension stream (418) and a M-N bit most significant bit (MSB) extension stream (426), the method comprising:
unpacking the bitstream, the unpacking including separating the corestream from the MSB extension stream and the LSB extension stream;
decoding the corestream into a lossy M-bit PCM decoded corestream using a core decoder (432);
decoding the MSB extension stream into a lossless decoded MSB extension stream using a lossless MSB decoder (434);
right-shifting (436) the decoded corestream by N bits to produce a right-shifted decoded corestream;
combining (438) the right-shifted decoded corestream with the decoded MSB extension stream to produce a summed output;
left-shifting (440) the summed output by N bits to produce a left-shifted summed output; and
combining (446) the left-shifted summed output with the LSB extension stream to form a lossless reconstruction of the original M-bit PCM audio signal.

4. The method of claim 3, wherein the corestream (408) includes 64 bands, and wherein the step of decoding the corestream includes:
zeroing out sub-band samples for an upper 32 bands of the 64 band corestream.

5. An encoder (400) configured to encode a scalable, lossless bitstream for M-bit PCM audio samples for decoding by a backward compatible lossless decoder, comprising:
a core encoder (404) configured to encode the M-bit PCM audio samples into a lossy M-bit corestream (408);
a packer (410) configured to pack the lossy M-bit corestream into a bitstream;
a core decoder (412) configured to decode the M-bit corestream into a reconstructed core signal (414);
means for separating the M-bit PCM audio samples into M-N bit MSB and N-bit LSB (418) portions;
means for right-shifting the reconstructed core signal by N bits to align it with the MSB portion;
a subtracting node (420) configured to subtract the reconstructed core signal from the MSB portion to form an M-N bit difference signal (422); and
a lossless encoder (422) configured to losslessly encode the difference signal;
wherein the packer is further configured to:
pack the N-bit LSB portion into the bitstream;
pack the encoded difference signal into the bitstream; and
pack the bit widths of the LSB portions into the bitstream.

6. The encoder of claim 5, wherein the encoder further comprises means for adding dither to the reconstructed core signal before the reconstructed core signal is right-shifted, and wherein the packer is further configured to pack a dither parameter into the bitstream.

7. A decoder configured to decode a bitstream for M-bit PCM audio samples, the bitstream comprising a corestream (408), an N-bit least significant bit (LSB) extension stream (418) and a M-N bit most significant bit (MSB) extension stream (426), the decoder comprising:
an unpacker (430) configured to unpack the bitstream and to separate the corestream from the MSB extension stream and the LSB extension stream;
a core decoder (432) configured to decode the corestream into a lossy M-bit PCM decoded corestream;
a lossless MSB decoder (434) configured to decode the MSB extension stream into a lossless decoded MSB extension stream (442);
means for right-shifting the decoded corestream by N bits to produce a right-shifted decoded corestream;
a summer (438) configured to combine the right-shifted decoded corestream with the decoded MSB extension stream to produce a summed output;
means for left-shifting the summed output by N bits to produce a left-shifted summed output;
means for combining the left-shifted summed output with the LSB extension stream to form a lossless reconstruction of the original M-bit PCM audio signal.

8. The decoder (432) of claim 7, wherein the corestream (408) includes 64 bands, and wherein the core decoder (432) is further configured to zero out sub-band samples for an upper 32 bands of the 64 band corestream.

## Patentansprüche

1. Verfahren zum Codieren eines skalierbaren verlustlosen Bitstreams für M-Bit-PCM-Audio-Samples zum Decodieren eines rückwärts kompatiblen verlustlosen Decodierers, beinhaltend:
Codieren der M-Bit-PCM-Audio-Samples in einen verlustbehafteten M-Bit-Core-Stream (408);
Packen des verlustbehafteten M-Bit-Core-Stream in einen Bitstream;
Decodieren des M-Bit-Core-Streams in ein rekonstruiertes Core-Signal (414);
Trennen (417) der M-Bit-PCM-Audio-Samples in M-N-Bit-MSB- und N-Bit-LSB- (418) Teile;
Packen des N-Bit-LSB-Teils in den Bitstream;
Rechtsschieben (415) des rekonstruierten Core-Signals um N-Bits, um es mit dem MSB-Teil auszurichten;
Subtrahieren (420) des rekonstruierten Core-Signals vom MSB-Teil, um ein M-N-Bit-Differenzsignal zu bilden (422);
verlustloses Codieren des Differenzsignals;
Packen des codierten Differenzsignals in den Bitstream; und
Packen der Bit-Breiten der LSB-Teile in den verlustlosen Bitstream.

2. Verfahren gemäß Anspruch 1, ferner beinhaltend Addieren von Dither zum rekonstruierten Core-Signal vor dem Rechtsschieben und Packen eines Dither-Parameters in den Bitstream.

3. Verfahren zum Decodieren eines Bitstreams für M-Bit-PCM-Audio-Samples, wobei der Bitstream einen Core-Stream (408), einen N-Bit-niedrigstwertigen-Bit- (LSB, least significant bit) Erweiterungsstream (418) und einen M-N-Bit-höchstwertigen-Bit- (MSB, most significat bit) Erweiterungsstream (426) beinhaltet, das Verfahren beinhaltend:
Entpacken des Bitstreams, das Entpacken umfassend
Trennen des Core-Streams vom MSB-Erweiterungsstream und vom LSB-Erweiterungsstream;
Decodieren des Core-Streams in einen verlustbehafteten M-Bit-PCM-decodierten Core-Stream mittels eines Core-Decodierers (432);
Decodieren des MSB-Erweiterungsstreams in einen verlustlosen decodierten MSB-Erweiterungsstream mittels eines verlustlosen MSB-Decodierers (434);
Rechtsschieben (436) des decodierten Core-Streams um N-Bits, um einen nach rechts verschobenen decodierten Core-Stream zu produzieren;
Kombinieren (438) des nach rechts verschobenen decodierten Core-Streams mit dem decodierten MSB-Erweiterungsstream, um einen summierten Ausgang zu produzieren;
Linksschieben (440) des summierten Ausgangs um N-Bits, um einen nach links verschobenen summierten Ausgang zu produzieren; und
Kombinieren (446) des nach links verschobenen summierten Ausgangs mit dem LSB-Erweiterungsstream, um eine verlustlose Rekonstruktion des originalen M-Bit-PCM-Audio-Signals zu bilden.

4. Verfahren gemäß Anspruch 3, wobei der Core-Stream (408) 64 Bänder umfasst, und wobei der Schritt des Decodierens des Core-Streams umfasst:
Auf-Null-Setzen von Teilband-Samples für ein oberes 32 Bänder des 64-Band-Core-Streams.

5. Codierer (400), konfiguriert, um einen skalierbaren verlustlosen Bitstream für M-Bit-PCM-Audio-Samples zum Decodieren eines rückwärts kompatiblen verlustlosen Decodierers zu codieren, beinhaltend:
einen Core-Codierer (404), konfiguriert, um die M-Bit-PCM-Audio-Samples in einen verlustbehafteten M-Bit-Core-Stream (408) zu codieren;
einen Packer (410), konfiguriert, um den verlustbehafteten M-Bit-Core-Stream in einen Bitstream zu packen;
einen Core-Decodierer (412), konfiguriert, um die M-Bit-Core-Streams in ein rekonstruiertes Core-Signal (414) zu decodieren;
Mittel zum Trennen der M-Bit-PCM-Audio-Samples in M-N-Bit-MSB- und N-Bit-LSB- (418) Teile;
Mittel zum Rechtsschieben des rekonstruierten Core-Signals um N-Bits, um es mit dem MSB-Teil auszurichten;
einen Subtrahierungsknoten (420), konfiguriert, um das rekonstruierte Core-Signal vom MSB-Teil zu subtrahieren, um ein M-N-Bit-Differenzsignal zu bilden (422); und
einen verlustlosen Codierer (422), konfiguriert, um das Differenzsignal verlustlos zu codieren; wobei der Packer ferner konfiguriert ist, um:
den N-Bit-LSB-Teil in den Bitstream zu packen;
das codierte Differenzsignal in den Bitstream zu packen; und
die Bit-Breiten der LSB-Teile in den Bitstream zu packen.

6. Codierer gemäß Anspruch 5, wobei der Codierer ferner Mittel beinhaltet zum Addieren von Dither zum rekonstruierten Core-Signal, bevor das rekonstruierte Core-Signal nach rechts verschoben wird, und wobei der Packer ferner konfiguriert ist, um einen Dither-Parameter in den Bitstream zu packen.

7. Decodierer, konfiguriert, um einen Bitstream für M-Bit-PCM-Audio-Samples zu decodieren, wobei der Bitstream einen Core-Stream (408), einen N-Bit-niedrigstwertigen-Bit- (LSB, least significant bit) Erweiterungsstream (418) und einen M-N-Bit-höchstwertigen-Bit- (MSB, most significant bit) Erweiterungsstream (426) beinhaltet, der Decodierer beinhaltend:
einen Entpacker (403), konfiguriert, um den Bitstream zu entpacken und den Core-Stream vom MSB-Erweiterungsstream und vom LSB-Erweiterungsstream zu trennen;
einen Core-Decodierer (432), konfiguriert, um den Core-Stream in einen verlustbehafteten M-Bit-PCM-decodierten Core-Stream zu decodieren;
einen verlustlosen MSB-Decodierer (434), konfiguriert, um den MSB-Erweiterungsstream in einen verlustlosen decodierten MSB-Erweiterungsstream (442) zu decodieren;
Mittel zum Rechtsschieben des decodierten Core-Streams um N-Bits, um einen nach rechts verschobenen decodierten Core-Stream zu produzieren;
einen Summierer (438), konfiguriert, um den nach rechts verschobenen decodierten Core-Stream mit dem decodierten MSB-Erweiterungsstream zu kombinieren, um einen summierten Ausgang zu produzieren;
Mittel zum Linksschieben des summierten Ausgangs um N-Bits, um einen nach links verschobenen summierten Ausgang zu produzieren;
Mittel zum Kombinieren des nach links verschobenen summierten Ausgangs mit dem LSB-Erweiterungsstream, um eine verlustlose Rekonstruktion des originalen M-Bit-PCM-Audio-Signals zu bilden.

8. Decodierer (432) gemäß Anspruch 7, wobei der Core-Stream (408) 64 Bänder umfasst, und wobei der Core-Decodierer (432) ferner konfiguriert ist, um Teilband-Samples für ein oberes 32 Bänder des 64-Band-Core-Streams auf Null zu setzen.

## Revendications

1. Procédé de codage d'un flux binaire scalable, sans perte, d'échantillons audio MIC de M bits destiné à être décodé par un décodeur sans perte rétrocompatible, comprenant :
le codage des échantillons audio MIC de M bits en un flux primaire de M bits à perte (408) ;
l'insertion du flux primaire de M bits à perte dans un flux binaire ;
le décodage du flux primaire de M bits en un signal primaire reconstruit (414) ;
la séparation (417) des échantillons audio MIC de M bits en parties MSB de M-N bits et LSB de N bits (418) ;
l'insertion de la partie LSB de N bits dans le flux binaire ;
le décalage à droite (415) du signal primaire reconstruit par N bits pour l'aligner avec la partie MSB ;
la soustraction (420) du signal primaire reconstruit de la partie MSB pour former un signal de différence de M-N bits (422) ;
le codage sans perte du signal de différence ;
l'insertion du signal de différence codé dans le flux binaire ; et
l'insertion des largeurs de bit des parties LSB dans le flux binaire sans perte.

2. Procédé selon la revendication 1, comprenant en outre l'ajout de dither au signal primaire reconstruit avant le décalage à droite et l'insertion d'un paramètre de dither dans le flux binaire.

3. Procédé de décodage d'un flux binaire d'échantillons audio MIC de M bits, le flux binaire comprenant un flux primaire (408), un flux d'extension de poids faible (LSB) de N bits (418) et un flux d'extension de poids fort (MSB) de M-N bits (426), le procédé comprenant :
l'extraction du flux binaire, l'extraction comportant la séparation du flux primaire du flux d'extension MSB et du flux d'extension LSB ;
le décodage du flux primaire en un flux primaire décodé MIC de M bits à perte avec un décodeur primaire (432) ;
le décodage du flux d'extension MSB en un flux d'extension MSB décodé sans perte avec un décodeur MSB sans perte (434) ;
le décalage à droite (436) du flux primaire décodé par N bits pour produire un flux primaire décodé décalé à droite ;
la combinaison (438) du flux primaire décodé décalé à droite avec le flux d'extension MSB décodé pour produire une sortie additionnée ;
le décalage à gauche (440) de la sortie additionnée par N bits pour produire une sortie additionnée décalée à gauche ; et
la combinaison (446) de la sortie additionnée décalée à gauche avec le flux d'extension LSB pour former une reconstruction sans perte du signal audio MIC de M bits d'origine.

4. Procédé selon la revendication 3, dans lequel le flux primaire (408) comporte 64 bandes, et dans lequel l'étape de décodage du flux primaire comporte :
la mise à zéro des échantillons de sous-bande pour 32 bandes supérieures du flux primaire de 64 bandes.

5. Codeur (400) configuré pour coder un flux binaire scalable, sans perte, d'échantillons audio MIC de M bits destiné à être décodé par un décodeur sans perte rétrocompatible, comprenant :
un codeur primaire (404) configuré pour coder les échantillons audio MIC de M bits en un flux primaire de M bits à perte (408) ;
un moyen d'insertion (410) configuré pour insérer le flux primaire de M bits à perte dans un flux binaire ;
un décodeur primaire (412) configuré pour décoder le flux primaire de M bits en un signal primaire reconstruit (414) ;
un moyen de séparation des échantillons audio MIC de M bits en parties MSB de M-N bits et LSB de N bits (418) ;
un moyen de décalage à droite du signal primaire reconstruit par N bits pour l'aligner avec la partie MSB ;
un noeud de soustraction (420) configuré pour soustraire le signal primaire reconstruit de la partie MSB pour former un signal de différence de M-N bits (422) ; et
un codeur sans perte (422) configuré pour coder sans perte le signal de différence ;
dans lequel le moyen d'insertion est configuré en outre pour :
insérer la partie LSB de N bits dans le flux binaire ;
insérer le signal de différence codé dans le flux binaire ; et
insérer les largeurs de bit des parties LSB dans le flux binaire.

6. Codeur selon la revendication 5, le codeur comprenant en outre un moyen d'addition de dither au signal primaire reconstruit avant le décalage à droite du signal primaire reconstruit et dans lequel le moyen d'insertion est configuré en outre pour insérer un paramètre de dither dans le flux binaire.

7. Décodeur configuré pour décoder un flux binaire d'échantillons audio MIC de M bits, le flux binaire comprenant un flux primaire (408), un flux d'extension de poids faible (LSB) de N bits (418) et un flux d'extension de poids fort (MSB) de M-N bits (426), le décodeur comprenant :
un moyen d'extraction (430) configuré pour extraire le flux binaire et séparer le flux primaire du flux d'extension MSB et du flux d'extension LSB ;
un décodeur primaire (432) configuré pour décoder le flux primaire en un flux primaire décodé MIC de M bits à perte ;
un décodeur MSB sans perte (434) configuré pour décoder le flux d'extension MSB en un flux d'extension MSB décodé sans perte (442) ;
un moyen de décalage à droite du flux primaire décodé par N bits pour produire un flux primaire décodé décalé à droite ;
un sommateur (438) configuré pour combiner le flux primaire décodé décalé à droite avec le flux d'extension MSB décodé pour produire une sortie additionnée ;
un moyen de décalage à gauche de la sortie additionnée par N bits pour produire une sortie additionnée décalée à gauche ;
un moyen de combinaison de la sortie additionnée décalée à gauche avec le flux d'extension LSB pour former une reconstruction sans perte du signal audio MIC de M bits d'origine.

8. Décodeur (432) selon la revendication 7, dans lequel le flux primaire (408) comporte 64 bandes, et dans lequel le décodeur primaire (432) est configuré en outre pour mettre à zéro les échantillons de sous-bande pour 32 bandes supérieures du flux primaire de 64 bandes.
